(19) 

Europäisches Patentamt

European Patent Office

Office européen des brevets

(11) **EP 4 703 070 A1**

(12) **EUROPEAN PATENT APPLICATION**
published in accordance with Art. 153(4) EPC

(43) Date of publication:
**04.03.2026 Bulletin 2026/10**

(21) Application number: **23935372.5**

(22) Date of filing: **28.04.2023**

(51) International Patent Classification (IPC):
**B23B 27/14** *(2006.01)*   **C23C 14/06** *(2006.01)*

(52) Cooperative Patent Classification (CPC):
**B23B 27/14; C23C 14/06**

(86) International application number:
**PCT/JP2023/016836**

(87) International publication number:
**WO 2024/224594 (31.10.2024 Gazette 2024/44)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Sumitomo Electric Hardmetal Corp.**
**Itami-shi, Hyogo 664-0016 (JP)**

(72) Inventors:
- **SUZUKI, Yuta**
  **Itami-shi, Hyogo 664-0016 (JP)**
- **KANAOKA, Hideaki**
  **Itami-shi, Hyogo 664-0016 (JP)**
- **IMAMURA, Shinya**
  **Itami-shi, Hyogo 664-0016 (JP)**

(74) Representative: **Boult Wade Tennant LLP**
**Salisbury Square House**
**8 Salisbury Square**
**London EC4Y 8AP (GB)**

(54) **CUTTING TOOL**

(57)    A cutting tool includes a substrate and a coating film provided on the substrate, wherein the coating film includes a first layer, the first layer consists of a multilayer structure in which a first unit layer and a second unit layer are alternately layered, an average thickness of the first unit layer is 2 nm or more and 50 nm or less, an average thickness of the second unit layer is 2 nm or more and 50 nm or less, an average thickness of the first layer is 1.0 $\mu$m or more and 20 $\mu$m or less, the first unit layer consists of $Ti_aAl_{1-a-b}B_bN$, where $0.30 \leq a \leq 0.50$, and $0 < b \leq 0.10$, the second unit layer consists of $Ti_cAl_{1-c}N$, where $0.70 \leq c \leq 1.00$, and in the first layer, a percentage $(T2/T1) \times 100$ of T2, the number of atoms of titanium, to T1, a total of the numbers of atoms of titanium and aluminum, is 60% or more.

FIG.1

EP 4 703 070 A1

**Description**

TECHNICAL FIELD

The present disclosure relates to a cutting tool.

BACKGROUND ART

Conventionally, in order to improve performance of a cutting tool, development has been advanced with regard to a coating film that coats a surface of a substrate consisting of a cemented carbide, a cubic boron nitride sintered material, or the like (for example, PTL 1 and PTL 2).

CITATION LIST

PATENT LITERATURE

PTL 1: Japanese Patent Laying-Open No. 2017-193004
PTL 2: Japanese Patent Laying-Open No. 2011-224717

SUMMARY OF INVENTION

A cutting tool of the present disclosure is a cutting tool comprising a substrate and a coating film provided on the substrate, wherein

the coating film includes a first layer,
the first layer consists of a multilayer structure in which a first unit layer and a second unit layer are alternately layered,
an average thickness of the first unit layer is 2 nm or more and 50 nm or less,
an average thickness of the second unit layer is 2 nm or more and 50 nm or less,
an average thickness of the first layer is 1.0 $\mu$m or more and 20 $\mu$m or less,
the first unit layer consists of $Ti_aAl_{1-a-b}B_bN$, where

$$0.30 \leq a \leq 0.50,$$

and

$$0 < b \leq 0.10,$$

the second unit layer consists of $Ti_cAl_{1-c}N$, where

$$0.70 \leq c \leq 1.00,$$

and
in the first layer, a percentage $(T2/T1) \times 100$ of T2, the number of atoms of titanium, to T1, a total of the numbers of atoms of titanium and aluminum, is 60% or more.

BRIEF DESCRIPTION OF DRAWINGS

[Fig. 1] Fig. 1 is a schematic cross sectional view showing an exemplary configuration of a cutting tool according to a first embodiment.
[Fig. 1A] Fig. 1A is a schematic cross sectional view showing an exemplary configuration of a cutting tool according to a second embodiment.
[Fig. 2] Fig. 2 is a diagram for illustrating a measurement region when measuring a diameter of a maximum inscribed circle of a crystal grain of a first layer.

[Fig. 3] Fig. 3 is a diagram for illustrating a method of measuring the diameter of the maximum inscribed circle of the crystal grain of the first layer, and schematically showing a bright visual field image of a measurement visual field.
[Fig. 3A] Fig. 3A is a diagram for illustrating a positional relation between the crystal grain and each of first and second unit layers.
[Fig. 4] Fig. 4 is a schematic cross sectional view showing an exemplary configuration of a film forming device.
[Fig. 5] Fig. 5 is a schematic cross sectional view showing the exemplary configuration of the film forming device.

DETAILED DESCRIPTION

[Problem to be Solved by the Present Disclosure]

In recent years, a demand for cost reduction has been increased and a tool has been required to have a longer life. For example, there has been required a cutting tool having a long tool life in both high-speed low-feed processing and low-speed high-feed processing.
Thus, it is an object of the present disclosure to provide a cutting tool having a long tool life.

[Advantageous Effect of the Present Disclosure]

The cutting tool of the present disclosure can have a long tool life.

[Description of Embodiments]

First, embodiments of the present disclosure will be listed and described.

(1) A cutting tool of the present disclosure is a cutting tool comprising a substrate and a coating film provided on the substrate, wherein

the coating film includes a first layer,
the first layer consists of a multilayer structure in which a first unit layer and a second unit layer are alternately layered,
an average thickness of the first unit layer is 2 nm or more and 50 nm or less,
an average thickness of the second unit layer is 2 nm or more and 50 nm or less,
an average thickness of the first layer is 1.0 $\mu$m or more and 20 $\mu$m or less,
the first unit layer consists of $Ti_aAl_{1-a-b}B_bN$, where

$$0.30 \leq a \leq 0.50,$$

and

$$0 < b \leq 0.10,$$

the second unit layer consists of $Ti_cAl_{1-c}N$, where

$$0.70 \leq c \leq 1.00,$$

and
in the first layer, a percentage $(T2/T1) \times 100$ of T2, the number of atoms of titanium, to T1, a total of the numbers of atoms of titanium and aluminum, is 60% or more.

The cutting tool of the present disclosure can have a long tool life.
(2) In (1), a nano indentation hardness of the first layer at 25°C may be 30 GPa or more. This leads to an improved wear resistance of the cutting tool.
(3) A cutting tool of the present disclosure is a cutting tool comprising a substrate and a coating film provided on the substrate, wherein

the coating film includes a first-A layer,
the first-A layer consists of a multilayer structure in which a first unit layer and a third unit layer are alternately layered,

an average thickness of the first unit layer is 2 nm or more and 50 nm or less,
an average thickness of the third unit layer is 2 nm or more and 50 nm or less,
an average thickness of the first-A layer is 1.0 $\mu$m or more and 20 $\mu$m or less,
the first unit layer consists of $Ti_aAl_{1-a-b}B_bN$, where

$$0.30 \leq a \leq 0.50,$$

and

$$0 < b \leq 0.10,$$

the third unit layer consists of $Ti_dAl_{1-d-e}B_eN$, where

$$0.70 \leq d < 1.00,$$

and

$$0 < e \leq 0.10,$$

and
in the first-A layer, a percentage $(T4/T3) \times 100$ of T4, the number of atoms of titanium, to T3, a total of the numbers of atoms of titanium and aluminum, is 60% or more.

The cutting tool of the present disclosure can have a long tool life.

(4) In (3), a nano indentation hardness of the first-A layer at 25°C may be 30 GPa or more. This leads to an improved wear resistance of the cutting tool.

[Details of Embodiments of the Present Disclosure]

A specific example of the cutting tool of the present disclosure will be described below with reference to figures. In the figures of the present disclosure, the same reference characters represent the same or corresponding portions. Further, a dimensional relation such as a length, a width, a thickness, or a depth is appropriately changed for clarity and simplification of the figures, and therefore do not necessarily represent an actual dimensional relation.

In the present disclosure, the expression "A to B" represents a range of lower to upper limits (i.e., A or more and B or less), and when no unit is indicated for A and a unit is indicated only for B, the unit of A is the same as the unit of B.

When a compound or the like is expressed by a chemical formula in the present disclosure and an atomic ratio is not particularly limited, it is assumed that all the conventionally known atomic ratios are included, and the atomic ratio should not be necessarily limited only to one in the stoichiometric range. For example, when "TiN" is described, the atomic ratio of TiN includes all the conventionally known atomic ratios.

In the present disclosure, when one or more numerical values are described as each of lower and upper limits of a numerical range, it is assumed that a combination of any one numerical value described as the lower limit and any one numerical value described as the upper limit is also disclosed. For example, in the case where a1 or more, b1 or more, and c1 or more are each described as the lower limit and a2 or less, b2 or less, and c2 or less are each described as the upper limit, it is assumed that a1 or more and a2 or less, a1 or more and b2 or less, a1 or more and c2 or less, b1 or more and a2 or less, b1 or more and b2 or less, b1 or more and c2 or less, c1 or more and a2 or less, c1 or more and b2 or less, and c1 or more and c2 or less are disclosed.

[First Embodiment: Cutting Tool]

A cutting tool according to one embodiment (hereinafter, also referred to as "first embodiment") of the present disclosure is a cutting tool comprising a substrate and a coating film provided on the substrate, wherein

the coating film includes a first layer,
the first layer consists of a multilayer structure in which a first unit layer and a second unit layer are alternately layered,
an average thickness of the first unit layer is 2 nm or more and 50 nm or less,
an average thickness of the second unit layer is 2 nm or more and 50 nm or less,
an average thickness of the first layer is 1.0 $\mu$m or more and 20 $\mu$m or less,

the first unit layer consists of $Ti_aAl_{1-a-b}B_bN$, where

$$0.30 \leq a \leq 0.50,$$

and

$$0 < b \leq 0.10,$$

the second unit layer consists of $Ti_cAl_{1-c}N$, where

$$0.70 \leq c \leq 1.00,$$

and

in the first layer, a percentage $(T2/T1) \times 100$ of T2, the number of atoms of titanium, to T1, a total of the numbers of atoms of titanium and aluminum, is 60% or more.

The cutting tool of the present disclosure can have a long tool life. A reason therefor is presumed as follows.

(i) The coating film of the cutting tool of the present disclosure includes the first layer consisting of the multilayer structure in which the first unit layer and the second unit layer are alternately layered. The first unit layer and the second unit layer have compositions different from each other. Therefore, in the vicinity of an interface between the first unit layer and the second unit layer, a crack generated during use of the cutting tool can be suppressed from progressing from the surface of the coating film. Moreover, since each of the average thickness of the first unit layer and the average thickness of the second unit layer is 2 nm or more and 50 nm or less and the average thickness of the first layer is 1.0 μm or more and 20 μm or less, the numbers of the first and second unit layers in the first layer is large and the effect of suppressing the progress of crack is further improved. Hence, significant damage of the coating film can be suppressed, with the result that the cutting tool has a long tool life.

(ii) The first unit layer consists of $Ti_aAl_{1-a-b}B_bN$ (where $0.30 \leq a \leq 0.50$ and $0 < b \leq 0.10$). The hardness of the first unit layer is improved because a small amount of boron (B) is added to TiAlN. The second unit layer consists of $Ti_cAl_{1-c}N$ (where $0.70 \leq c \leq 1.00$). The second unit layer has a high titanium (Ti) content ratio and has an excellent high-temperature stability. In the present disclosure, since the first layer consists of the multilayer structure in which the first unit layer having the high hardness and the second unit layer having the excellent high-temperature stability are alternately layered, stable hardness can be obtained even at a high temperature and crater wear resistance is improved. The crater wear is wear generated mainly at a rake face of the cutting tool due to frictional heat between the cutting tool and a chip. Further, since the first layer consists of the multilayer structure in which the first unit layer having the high hardness and the second unit layer having lower hardness than that of the first unit layer are alternately layered, breakage resistance is also improved. Thus, the crater wear resistance and the breakage resistance of the coating film are improved in a balanced manner, with the result that the cutting tool has a long tool life.

(iii) The first unit layer and the second unit layer are different in terms of Ti content ratio and Al content ratio. Therefore, the first unit layer and the second unit layer have different crystal lattices, and a strain of the crystal lattice is generated in the first layer and the first layer can have high hardness.

(iv) In the first layer, the percentage $(T2/T1) \times 100$ of T2, the number of atoms of titanium, to T1, the total of the number of atoms of titanium and aluminum, is 60% or more. According to this, the first layer can have excellent crater wear resistance, with the result that the cutting tool has a long tool life.

<Cutting Tool>

As long as the cutting tool of the first embodiment is a cutting tool, the shape, purpose of use, and the like thereof are not particularly limited. Examples of the cutting tool according to the first embodiment include a drill, an end mill, an indexable insert for milling, an indexable insert for turning, a metal saw, a gear cutting tool, a reamer, a tap, a crankshaft pin milling insert, and the like.

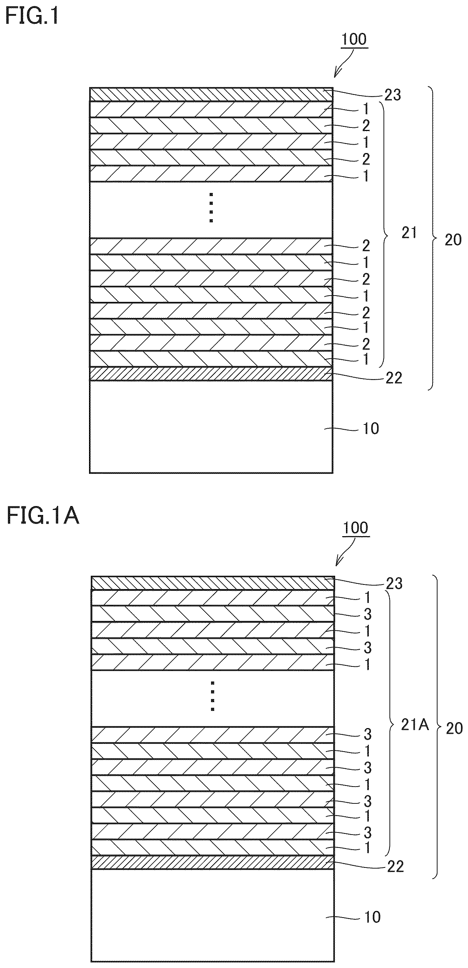

Fig. 1 is a schematic partial cross sectional view showing an exemplary configuration of the cutting tool according to the first embodiment. A cutting tool 100 includes a substrate 10 and a coating film 20 provided on substrate 10. Coating film 20 includes a first layer 21, and first layer 21 consists of a multilayer structure in which first unit layers 1 and second unit layers 2 are alternately layered.

<<Substrate>>

Substrate 10 is not particularly limited. Substrate 10 can be composed of, for example, a cemented carbide, cermet, high-speed steel, ceramic, cubic boron nitride sintered material, diamond sintered material, or the like. Substrate 10 is preferably composed of the cemented carbide. This is because the cemented carbide has excellent wear resistance.

The cemented carbide is a sintered material including WC (tungsten carbide) grains as a main component. The cemented carbide includes a hard phase and a binder phase. The hard phase contains the WC grains. The binder phase binds the WC grains together. The binder phase contains, for example, Co (cobalt) or the like. The binder phase may further contain, for example, TiC (titanium carbide), TaC (tantalum carbide), NbC (niobium carbide), or the like.

The cemented carbide may contain an impurity inevitably introduced therein in the course of manufacturing. The cemented carbide may also include free carbon or an abnormal layer called "η layer" in its structure. Further, the cemented carbide may be subjected to a surface modification treatment. For example, the cemented carbide may include a β-free layer or the like in its surface.

The cemented carbide may contain 85 mass% or more and 98 mass% or less of the WC grains and 2 mass% or more and 15 mass% or less of Co. The average grain size of the WC grains may be 0.2 $\mu$m or more and 4 $\mu$m or less.

Co is softer than the WC grains. When a surface of substrate 10 is subjected to ion bombardment treatment, soft Co can be removed as described later. Since the cemented carbide has the above-described composition and the WC grains have the above-described average grain size, an appropriate degree of unevenness is formed in the surface from which the Co has been removed. It is considered that by forming coating film 20 on such a surface, an anchor effect is exhibited to improve adhesion between coating film 20 and substrate 10.

Here, the grain size of each WC grain indicates the diameter of a circle circumscribed around a two-dimensional projection image of the WC grain. The grain size is measured using a scanning electron microscope (SEM) or a transmission electron microscope (TEM). That is, the cemented carbide is cut and the cut surface is observed by the SEM or TEM. In the observation image, the diameter of the circle circumscribed around the WC grain is regarded as the grain size of the WC grain. In the observation image, the grain sizes of 10 or more (preferably 50 or more, and more preferably 100 or more) WC grains randomly extracted are measured, and the arithmetic average value thereof is defined as the average grain size of the WC grains. For the observation, it is desirable to process the cross section of the cut surface by a cross section polisher (CP), a focused ion beam (FIB), or the like.

<<Coating Film>>

Coating film 20 is provided on substrate 10. Coating film 20 may be provided on a portion of the surface of substrate 10, or may be provided on a whole of the surface thereof. It should be noted that coating film 20 is provided at least at a portion of the surface of substrate 10 corresponding to a cutting edge. In the present disclosure, the portion of the surface of substrate 10 corresponding to the cutting edge means a region in a distance of at least 500 $\mu$m or less or 2 mm or less from a cutting edge ridgeline in the surface of substrate 10. As long as the effect of the present disclosure is not impaired, a coating film not formed on at least a part of the portion corresponding to the cutting edge is not departed from the scope of the present disclosure.

Coating film 20 includes first layer 21. Coating film 20 may include another layer in addition to first layer 21 as long as the effect of the present disclosure is not impaired. For example, coating film 20 can include one or both of a second layer 22 provided between substrate 10 and first layer 21 and a third layer 23 provided on the outermost surface of coating film 20. For the second layer, a known underlying layer can be applied. Examples of the underlying layer include a TiCN layer, a TiN layer, a TiCNO layer, and the like. For the third layer, a known surface layer can be applied. Examples of the surface layer include a TiC layer, a TiN layer, a TiCN layer, and the like.

The layering configuration of coating film 20 does not need to be uniform across the whole of coating film 20, and may be partially different.

The thickness of coating film 20 may be 1.0 $\mu$m or more and 25 $\mu$m or less. When the thickness of coating film 20 is 1.0 $\mu$m or more, wear resistance is improved. When the thickness of coating film 20 is 25 $\mu$m or less, the breakage resistance is improved. The thickness of coating film 20 may be 2.0 $\mu$m or more and 16 $\mu$m or less, or 3.0 $\mu$m or more and 12 $\mu$m or less. Here, the thickness of the coating film means the total of the thicknesses of the respective layers included in the coating film. Examples of the "layers included in the coating film" include the first layer, the second layer, the third layer, and the like.

The thickness of each of the layers included in the coating film is measured by obtaining a thin-piece sample (hereinafter, also referred to as "cross section sample") with a cross section parallel to the normal direction of the surface of the cutting tool and by observing the cross section sample using a scanning transmission electron microscope (STEM). Examples of the scanning transmission electron microscope include JEM-2100F (trade name) provided by JEOL. An observation magnification for the cross section sample is 5,000x to 10,000x, the thicknesses at five positions of the layer are measured, and the arithmetic average value thereof is defined as the "thickness of each layer".

As long as the measurement is performed for the same cutting tool, it has been confirmed that there are no variations in measurement results even when the measurement positions are arbitrarily selected.

<<First Layer>>

First layer 21 consists of the multilayer structure in which first unit layers 1 and second unit layers 2 are alternately layered. The number of the layered layers is not particularly limited as long as each of the average thickness of first unit layer 1 and the average thickness of second unit layer 2 is 2 nm or more and 50 nm or less and the average thickness of the first layer is 1.0 μm or more and 20 μm or less. The number of the layered layers indicates each of the number of first unit layers 1 included in first layer 21 and the number of second unit layers 2 included therein. The number of the layered layers may be 10 or more and 5000 or less, may be 200 or more and 5000 or less, may be 400 or more and 2000 or less, or may be 500 or more and 1000 or less. In first layer 21, the layer closest to substrate 10 may be first unit layer 1 or second unit layer 2. Moreover, in first layer 21, the layer farthest away from substrate 10 may be first unit layer 1 or second unit layer 2.

The average thickness of the first layer is 1.0 μm or more and 20 μm or less. When the average thickness of the first layer is 1.0 μm or more, the wear resistance is improved. When the average thickness of the first layer is 20 μm or less, the breakage resistance is improved. The lower limit of the average thickness of the first layer is 1.0 μm or more, may be 2.0 μm or more, or may be 3.0 μm or more. The upper limit of the average thickness of the first layer is 20 μm or less, may be 18 μm or less, may be 16 μm or less, or may be 12 μm or less. The average thickness of the first layer is 1.0 μm or more and 20 μm or less, may be 2.0 μm or more and 16 μm or less, or may be 3.0 μm or more and 12 μm or less.

<<Average Thickness of First Unit Layer and Average Thickness of Second Unit Layer>>

The average thickness of first unit layer 1 is 2 nm or more and 50 nm or less, and the average thickness of second unit layer 2 is 2 nm or more and 50 nm or less. By alternately layering such thin layers in the first layer, progress of crack can be suppressed. When one or both of the average thickness of first unit layer 1 and the average thickness of second unit layer 2 is less than 2 nm, the compositions of first unit layer 1 and second unit layer 2 may be mixed with each other to reduce the effect of suppressing the progress of crack. When one or both of the average thickness of first unit layer 1 and the average thickness of second unit layer 2 is more than 50 nm, an effect of suppressing delamination may be reduced. The average thickness of the first unit layer and the average thickness of the second unit layer may be the same or different.

The lower limit of the average thickness of the first unit layer is 2 nm or more, may be 4 nm or more, may be 6 nm or more, or may be 8 nm or more. The upper limit of the average thickness of the first unit layer is 50 nm or less, may be 46 nm or less, may be 40 nm or less, or may be 30 nm or less. The average thickness of the first unit layer is 2 nm or more and 50 nm or less, may be 4 nm or more and 40 nm or less, or may be 6 nm or more and 30 nm or less.

The lower limit of the average thickness of the second unit layer is 2 nm or more, may be 4 nm or more, may be 6 nm or more, or may be 8 nm or more. The upper limit of the average thickness of the second unit layer is 50 nm or less, may be 46 nm or less, may be 40 nm or less, or may be 30 nm or less. The average thickness of the second unit layer is 2 nm or more and 50 nm or less, may be 4 nm or more and 40 nm or less, or may be 6 nm or more and 30 nm or less.

Each of the average thickness of the first unit layer and the average thickness of the second unit layer is measured as follows. A thin-piece sample (hereinafter, also referred to as "cross section sample") of the cutting tool with a cross section parallel to the normal direction of the surface of the cutting tool is obtained. The cross section sample is observed using a scanning transmission electron microscope (STEM). Examples of the scanning transmission electron microscope include JEM-2100F (trade name) provided by JEOL. An observation magnification for the cross section sample is appropriately adjusted in accordance with each of the thicknesses of first unit layer 1 and second unit layer 2. For example, the observation magnification can be about 1,000,000x. In one first unit layer, the thicknesses at five positions are measured. The arithmetic average value of the thicknesses at the five positions of the first unit layer is calculated, and the arithmetic average value thereof is defined as the average thickness of the first unit layer. In one second unit layer, the thicknesses at five positions are measured.

For each of five different first unit layers, the average thickness of the first unit layer is measured in the procedure described above. The arithmetic average value of the average thicknesses of the five first unit layers is found. In the present disclosure, the arithmetic average value thereof is defined as the average thickness of the first unit layer. For each of the five different second unit layers, the average thickness of the second unit layer is measured in the procedure described above. The arithmetic average value of the average thicknesses of the five second unit layers is found. In the present disclosure, the arithmetic average value thereof is defined as the average thickness of the second unit layer.

As long as the measurement is performed for the same cutting tool, it has been confirmed that there are no variations in measurement results even when the measurement positions are arbitrarily selected.

<<Compositions of First Unit Layer and Second Unit Layer>>

In the cutting tool of the present disclosure, the first unit layer consists of $Ti_aAl_{1-a-b}B_bN$, where $0.30 \leq a \leq 0.50$ and $0 < b \leq 0.10$, and the second unit layer consists of $Ti_cAl_{1-c}N$, where $0.70 \leq c \leq 1.00$. As long as the effect of the present disclosure is not impaired, the first unit layer can include an impurity in addition to $Ti_aAl_{1-a-b}B_bN$. The first unit layer can consist of $Ti_aAl_{1-a-b}B_bN$ and an impurity. As long as the effect of the present disclosure is not impaired, the second unit layer can include an impurity in addition to $Ti_cAl_{1-c}N$. The second unit layer can consist of $Ti_cAl_{1-c}N$ and an impurity. Examples of the impurity include carbon (C) and oxygen (O).

In the first unit layer, the lower limit of a is 0.30 or more, may be 0.35 or more, or may be 0.37 or more. The upper limit of a is 0.50 or less, may be 0.45 or less, or may be 0.40 or less. a may be $0.35 \leq a \leq 0.45$ or may be $0.37 \leq a \leq 0.40$.

In the first unit layer, the lower limit of b may be more than 0, may be 0.01 or more, may be 0.02 or more, or may be 0.04 or more. The upper limit of b is 0.10 or less, may be 0.08 or less, or may be 0.07 or less. b may be $0.01 \leq b \leq 0.08$ or may be $0.02 \leq b \leq 0.07$.

In the second unit layer, the lower limit of c may be 0.70 or more, 0.75 or more, or 0.80 or more. The upper limit of c is 1.00 or less, may be 0.95 or less, or may be 0.90 or less. c may be $0.75 \leq d \leq 0.95$ or may be $0.80 \leq d \leq 0.90$.

Each of a and b in $Ti_aAl_{1-a-b}B_bN$ of the first unit layer and c in $Ti_cAl_{1-c}N$ of the second unit layer is specified by measuring the composition of each layer using energy dispersive X-ray spectrometry (EDX). For the composition analysis, an EDX (TEM-EDX) accompanied with the transmission electron microscopy (TEM) is used. Examples of the EDX device include JED-2300 (trademark) provided by JEOL.

The composition analysis is performed in the following procedure. A thin-piece sample (hereinafter, also referred to as "cross section sample") with a cross section parallel to the normal direction of the surface of the cutting tool is obtained. While observing the cross section sample with the TEM, an EDX analysis is performed at each of five arbitrarily selected points in one first unit layer 1 or one second unit layer 2. The first unit layer and the second unit layer can be distinguished from each other by a contrast difference. Here, it is assumed that the "five arbitrarily selected points" are points selected from different crystal grains. Each of the compositions of the first unit layer and the second unit layer is specified by arithmetically averaging the composition ratios obtained for each element by the measurements at the five points.

For each of the five different first unit layers, the composition of the first unit layer is specified in the procedure described above. In the present disclosure, the average of the compositions of the five first unit layers is defined as the composition of the first unit layer, and a and b are specified based on this. For each of the five different second unit layers, the composition of the second unit layer is specified in the procedure described above. In the present disclosure, the average of the compositions of the five second unit layers is defined as the composition of the second unit layer, and c is specified based on this.

As long as the measurement is performed for the same cutting tool, it has been confirmed that there are no variations in measurement results even when the measurement points are arbitrarily selected.

<<Composition of First Layer>>

In the first layer, the percentage (T2/T1)$\times$ 100 (hereinafter, also referred to as "percentage (T2/T1)$\times$ 100") of T2, the number of atoms of titanium, to T1, the total of the numbers of atoms of titanium and aluminum, is 60% or more. According to this, the first layer can have excellent crater wear resistance. From the viewpoint of improving the crater wear resistance, the lower limit of the percentage (T2/T1)$\times$ 100 is 60% or more, may be 63% or more, or may be 66% or more. From the viewpoint of improving oxidation resistance, the upper limit of the percentage (T2/T1)$\times$100 may be 80% or less, may be 77% or less, or may be 75% or less. The percentage (T2/T1)$\times$ 100 may be 60% or more and 80% or less, may be 63% or more and 77% or less, or may be 66% or more and 75% or less.

The percentage (T2/T1)$\times$ 100 in the first layer is measured by the TEM-EDX. Examples of the EDX device include JED-2300 (trade name) provided by JEOL. The percentage (T2/T1)$\times$ 100 is measured in the following procedure.

A thin-piece sample (hereinafter, also referred to as "cross section sample") with a cross section parallel to the normal direction of the surface of the cutting tool is obtained. While observing the cross section sample using the TEM, the EDX analysis is performed in the first layer at arbitrarily selected five visual fields so as to measure the percentage (T2/T1)$\times$ 100 of T2, the number of atoms of titanium, to T1, the total of the numbers of atoms of titanium and aluminum. Here, the "arbitrarily selected five visual fields" are set so as not to overlap with one another. The range of one visual field is 200 $\times$ 200 nm. In the present disclosure, the arithmetic average of the percentages (T2/T1)$\times$ 100 obtained by the measurements of the five visual fields is defined as the percentage (T2/T1)$\times$100 in the first layer.

As long as the measurement is performed for the same cutting tool, it has been confirmed that there are no variations in measurement results even when the measurement points are arbitrarily selected.

<<Nano Indentation Hardness of First Layer>>

The nano indentation hardness of the first layer at 25°C may be 30 GPa or more. This leads to an improved wear resistance of the cutting tool. The lower limit of the nano indentation hardness may be 32 GPa or more, or may be 34 GPa or more. The upper limit of the nano indentation hardness is not particularly limited, but may be 60 GPa or less, may be 40 GPa or less, or may be 36 GPa or less from the viewpoint of manufacturing. The nano indentation hardness may be 30 GPa or more and 60 GPa or less, may be 32 GPa or more and 60 GPa or less, or may be 34 GPa or more and 60 GPa or less.

The nano indentation hardness of the first layer at 25°C is measured by a nano indentation method in accordance with a standard procedure defined in "ISO 14577-1: 2015 Metallic materials-Instrumented indentation test for hardness and materials parameters-". For a measurement device, "ENT-1100a" provided by Elionix) is used. A pressing load for an indenter is 1 g. In the cross section parallel to the normal direction of the surface of the cutting tool, the indenter is pressed onto the first layer in the direction perpendicular to the cross section (i.e., direction parallel to the surface of the cutting tool).

The above measurement is performed at five positions in one measurement sample. The average value of the nano indentation hardnesses at the five positions is defined as the nano indentation hardness of the first layer. It should be noted that data considered to apparently indicate an abnormal value is excluded.

As long as the measurement is performed for the same cutting tool, it has been confirmed that there are no variations in measurement results even when the measurement points are arbitrarily selected.

<<Diameter of Maximum Inscribed Circle of Crystal Grain of First Layer>>

The first layer consists of a plurality of crystal grains, and the diameter of the maximum inscribed circle of each crystal grain may be 5 nm or more and 500 nm or less. This leads to an improved crater wear resistance of the cutting tool. The first layer of the present disclosure may include not only the plurality of crystal grains but also a region that does not constitute a crystal grain (region in which an atomic arrangement is random) as long as the effect of the present disclosure is not impaired.

The upper limit of the diameter of the maximum inscribed circle of the crystal grain may be 500 nm or less, may be 450 nm or less, or may be 400 nm or less from the viewpoint of improving the wear resistance and the breakage resistance. The lower limit of the diameter of the maximum inscribed circle of the crystal grain may be 5 nm or more, may be 7 nm or more, or may be 10 nm or more from the viewpoint of suppressing film hardness from being decreased due to the crystal grain becoming excessively fine. The diameter of the maximum inscribed circle of the crystal grain may be 5 nm or more and 500 nm or less, may be 7 nm or more and 450 nm or less, or may be 10 nm or more and 400 nm or less.

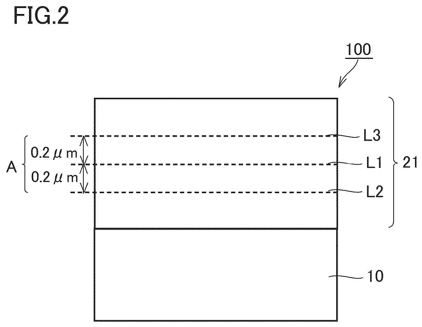

The diameter of the maximum inscribed circle of the crystal grain is measured in the following manner. A thin-piece sample (thickness: about 10 to 100 nm; hereinafter, also referred to as "cross section sample") of the cutting tool with a cross section parallel to the normal direction of the surface of the cutting tool is obtained. The cross section sample is observed using the transmission electron microscope (TEM) to obtain a bright visual field image. An observation magnification is 1,000,000x to 5,000,000x. As shown in Fig. 2, the bright visual field image is obtained to include a region A sandwiched between a line L2 and a line L3, line L2 being in a distance of 0.2 $\mu$m from a line L1 toward the substrate side, line L1 indicating the center of the first layer in the average thickness direction, line L3 being in a distance of 0.2 $\mu$m from line L1 toward the surface side of the coating film. A measurement visual field having a quadrangular shape of 150 nm $\times$ 150 nm is arbitrarily set in region A.

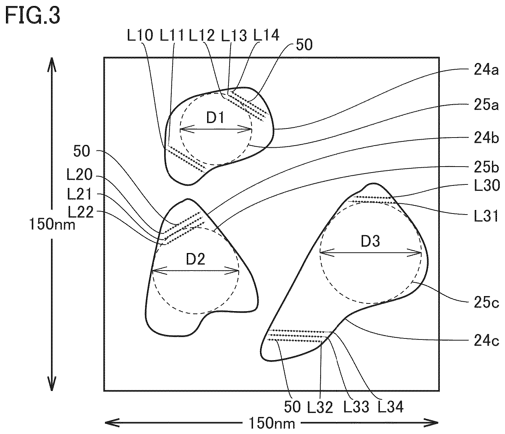

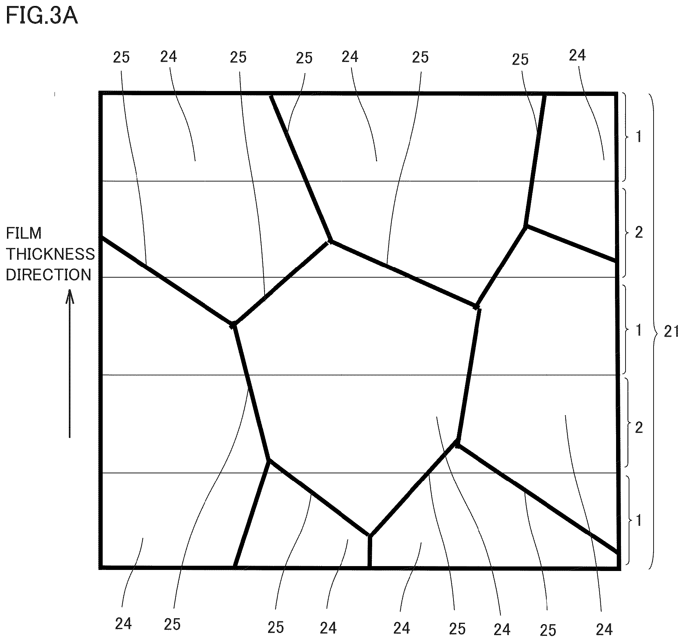

In the above measurement visual field, a region having an atomic arrangement of ±0.5° or less is specified, and the region is defined as a crystal grain. The region having an atomic arrangement of ±0.5° or less and a method of specifying the crystal grain will be described with reference to Fig. 3.

Fig. 3 is a schematic view showing an exemplary bright visual field image of the measurement visual field. In Fig. 3, atoms are indicated by black dots each denoted by reference numeral 50. It should be noted that in Fig. 3, parts of the atoms are shown. In the bright visual field image, atoms 50 regularly arranged are connected by line segments to attain the closest interatomic distances. In Fig. 3, the line segments are denoted by L10 to L14, L20 to L22, and L30 to L34. A region in which an angle between the line segments is ±0.5° or less (i.e., -0.5° or more and 0.5° or less) is defined as the crystal grain.

In Fig. 3, each of angles between line segments L10 to L14 is ±0.5° or less, and a region including these line segments corresponds to a crystal grain 24a. Each of angles between line segments L20 to L22 is ±0.5° or less, and a region including these line segments corresponds to a crystal grain 24b. Each of angles between line segments L30 to L34 is ±0.5° or less, and a region including these line segments corresponds to a crystal grain 24c.

The diameter of the maximum inscribed circle of each crystal grain in the measurement visual field is found. The diameter of the maximum inscribed circle means the diameter of the maximum inscribed circle that can be drawn inside the crystal grain and that is in contact with at least part of the outer edge of the crystal grain.

In Fig. 3, the diameter of a maximum inscribed circle 25a of crystal grain 24a is D1. The diameter of a maximum inscribed circle 25b of crystal grain 24b is D2. The diameter of a maximum inscribed circle 25c of crystal grain 24c is D3.

When each of D1, D2, and D3 is 50 nm or less, it is confirmed that the first layer shown in Fig. 3 consists of the plurality of crystal grains, and the diameter of the maximum inscribed circle of each of the crystal grains is 50 nm or less.

As long as the measurement is performed for the same cutting tool, it has been confirmed that there are no variations in measurement results of the diameters of the maximum inscribed circles of the crystal grains even when the measurement visual field is arbitrarily set.

In Fig. 3, a space exists among crystal grains 24a, 24b, 24c; however, a crystal grain actually exist in the space. Since the thickness of the cross section sample for the TEM is about 10 to 100 nm, information in the depth direction is also reflected in the bright visual field image. In a region in which a plurality of crystal grains overlap with each other in the thickness direction of the sample, a regular atomic arrangement cannot be confirmed on the bright visual field image. Therefore, the region in which the plurality of crystal grains overlap with each other is not determined as a crystal grain in the above-described specifying method.

<<Positional Relation Between Crystal Grain and Each of First and Second Unit Layers>>

A positional relation between a crystal grain and each of the first and second unit layers will be described with reference to Fig. 3A. Fig. 3A is a diagram schematically showing a cross section along a film thickness direction of the first layer according to the first embodiment. As shown in Fig. 3A, first layer 21 consists of the multilayer structure in which first unit layers 1 and second unit layers 2 are alternately layered. Fig. 3A shows a plurality of crystal grains 24, and boundaries between crystal grains 24 are shown as grain boundaries 25. Each crystal grain 24 may consist only of a first unit layer or a second unit layer. Further, each crystal grain 24 can exist to extend over one or more first unit layers and one or more second unit layers. That is, each crystal grain 24 can have a lamellar structure in which first and second unit layers are alternately layered.

[Second Embodiment: Cutting Tool]

A cutting tool according to one embodiment (hereinafter, also referred to as "second embodiment") of the present disclosure is a cutting tool comprising a substrate and a coating film provided on the substrate, wherein

the coating film includes a first-A layer,
the first-A layer consists of a multilayer structure in which a first unit layer and a third unit layer are alternately layered,
an average thickness of the first unit layer is 2 nm or more and 50 nm or less,
an average thickness of the third unit layer is 2 nm or more and 50 nm or less,
an average thickness of the first-A layer is 1.0 $\mu$m or more and 20 $\mu$m or less,
the first unit layer consists of $Ti_a Al_{1-a-b} B_b N$, where

$$0.30 \leq a \leq 0.50,$$

and

$$0 < b \leq 0.10,$$

the third unit layer consists of $Ti_d Al_{1-d-e} B_e N$, where

$$0.70 \leq d < 1.00,$$

and

$$0 < e \leq 0.10,$$

and
in the first-A layer, a percentage $(T4/T3) \times 100$ of T4, the number of atoms of titanium, to T3, a total of the numbers of atoms of titanium and aluminum, is 60% or more.

The cutting tool of the present disclosure can have a long tool life. A reason therefor is presumed as follows.

(i) The coating film of the cutting tool of the present disclosure includes the first-A layer consisting of the multilayer structure in which the first unit layer and the third unit layer are alternately layered. The first unit layer and the third unit layer have compositions different from each other. Therefore, in the vicinity of an interface between the first unit layer and the third unit layer, a crack generated during use of the cutting tool can be suppressed from progressing from the surface of the coating film. Moreover, since each of the average thickness of the first unit layer and the average thickness of the third unit layer is 2 nm or more and 50 nm or less and the average thickness of the first-A layer is 1.0 $\mu$m or more and 20 $\mu$m or less, the numbers of the first and third unit layers in the first-A layer is large and the effect of suppressing the progress of crack is further improved. Hence, significant damage of the coating film can be suppressed, with the result that the cutting tool has a long tool life.

(ii) The first unit layer consists of $Ti_aAl_{1-a-b}B_bN$ (where $0.30 \leq a \leq 0.50$ and $0 < b \leq 0.10$). The hardness of the first unit layer is improved because a small amount of boron (B) is added to TiAlN. The third unit layer consists of $Ti_dAl_{1-d-e}B_eN$ (where $0.70 \leq d < 1.00$ and $0 < e \leq 0.10$). The hardness of the third unit layer is improved because a small amount of boron (B) is added to TiAlN. The third unit layer has a high Ti content ratio and has an excellent high-temperature stability. In the present disclosure, since the first-A layer consists of the multilayer structure in which the first unit layer having the high hardness and the third unit layer having the excellent high-temperature stability are alternately layered, stable hardness can be obtained even at a high temperature and crater wear resistance is improved. Further, since the first-A layer consists of the multilayer structure in which the first unit layer having the high hardness and the third unit layer having lower hardness than that of the first unit layer are alternately layered, breakage resistance is also improved. Thus, the crater wear resistance and the breakage resistance of the coating film are improved in a balanced manner, with the result that the cutting tool has a long tool life.

(iii) The first unit layer and the third unit layer are different in terms of Ti content ratio and Al content ratio. Therefore, the first unit layer and the third unit layer have different crystal lattices, and a strain of the crystal lattice is generated in the first-A layer and the first-A layer can have high hardness.

(iv) In the first-A layer, the percentage $(T4/T3) \times 100$ of T4, the number of atoms of titanium, to T3, the total of the number of atoms of titanium and aluminum, is 60% or more. According to this, the first-A layer can have excellent crater wear resistance and excellent breakage resistance, with the result that the cutting tool has a long tool life.

<Cutting Tool>

The cutting tool according to the second embodiment can basically have the same configuration as that of the cutting tool according to the first embodiment except for the configuration of the first-A layer. Fig. 1A is a schematic partial cross sectional view showing an exemplary configuration of the cutting tool according to the second embodiment. A cutting tool 100 includes a substrate 10 and a coating film 20 provided on substrate 10. Coating film 20 includes a first-A layer 21A, and first-A layer 21A consists of a multilayer structure in which first unit layers 1 and third unit layers 3 are alternately layered.

In the second embodiment, the cutting tool and the substrate can have the same configuration as that of the first embodiment. In the second embodiment, the configuration of the coating film can be the same as that of the first embodiment except for the configuration of the first-A layer. Hereinafter, the "first-A layer" will be described.

<<First-A Layer>>

First-A layer 21A consists of the multilayer structure in which first unit layers 1 and third unit layers 3 are alternately layered. The number of the layered layers is not particularly limited as long as each of the average thickness of first unit layer 1 and the average thickness of third unit layer 3 is 2 nm or more and 50 nm or less and the average thickness of the first-A layer is 1.0 $\mu$m or more and 20 $\mu$m or less. The number of the layered layers indicates each of the number of first unit layers 1 included in first-A layer 21A and the number of third unit layers 3 included therein. The number of the layered layers may be 10 or more and 5000 or less, may be 200 or more and 5000 or less, may be 400 or more and 2000 or less, or may be 500 or more and 1000 or less. In the first-A layer, the layer closest to substrate 10 may be first unit layer 1 or third unit layer 3. Moreover, in the first-A layer, the layer farthest away from substrate 10 may be first unit layer 1 or third unit layer 3.

The average thickness of the first-A layer is 1.0 $\mu$m or more and 20 $\mu$m or less. When the average thickness of the first-A layer is 1.0 $\mu$m or more, the wear resistance is improved. When the average thickness of the first-A layer is 20 $\mu$m or less, the breakage resistance is improved. The lower limit of the average thickness of the first-A layer is 1.0 $\mu$m or more, may be 2.0 $\mu$m or more, and may be 3.0 $\mu$m or more. The upper limit of the average thickness of the first-A layer may be 20 $\mu$m or less, 18 $\mu$m or less, 16 $\mu$m or less, or 12 $\mu$m or less. The average thickness of the first-A layer is 1.0 $\mu$m or more and 20 $\mu$m or less, may be 2.0 $\mu$m or more and 16 $\mu$m or less, and may be 3.0 $\mu$m or more and 12 $\mu$m or less.

<<Average Thickness of First Unit Layer and Average Thickness of Third Unit Layer>>

The average thickness of the first unit layer can be as described in the first embodiment.

The lower limit of the average thickness of the third unit layer may be 2 nm or more, 4 nm or more, 6 nm or more, or 8 nm or more. The upper limit of the average thickness of the third unit layer may be 50 nm or less, 46 nm or less, 40 nm or less, or 30 nm or less. The average thickness of the third unit layer is 2 nm or more and 50 nm or less, may be 4 nm or more and 40 nm or less, and may be 6 nm or more and 30 nm or less.

The average thickness of the first unit layer and the average thickness of the third unit layer may be the same or different. Each of the average thickness of the first unit layer and the average thickness of the third unit layer is measured with the second unit layer being replaced with the third unit layer in the method of measuring each of the average thickness of the first unit layer and the average thickness of the second unit layer as described in the first embodiment.

<<Compositions of First Unit Layer and Third Unit Layer>>

In the cutting tool of the present disclosure, the first unit layer consists of $Ti_aAl_{1-a-b}B_bN$, where $0.30 \leq a \leq 0.50$ and $0 < b \leq 0.10$, and the third unit layer consists of $Ti_dAl_{1-d-e}B_eN$, where $0.70 \leq d < 1.00$ and $0 < e \leq 0.10$. As long as the effect of the present disclosure is not impaired, the first unit layer can include an impurity in addition to $Ti_aAl_{1-a-b}B_bN$. The first unit layer can consist of $Ti_aAl_{1-a-b}B_bN$ and an impurity. As long as the effect of the present disclosure is not impaired, the third unit layer can include an impurity in addition to $Ti_dAl_{1-d-e}B_eN$. The third unit layer can consist of $Ti_dAl_{1-d-e}B_eN$ and an impurity. Examples of the impurity include carbon (C) and oxygen (O).

The composition of the first unit layer can be as described in the first embodiment.

In the third unit layer, the lower limit of d is 0.70 or more, may be 0.75 or more, or 0.80 or more. The upper limit of d is less than 1.00, may be 0.99 or less, may be 0.95 or less, or may be 0.90 or less. d may be $0.70 \leq d \leq 0.99$, may be $0.75 \leq d \leq 0.99$, or may be $0.80 \leq d \leq 0.95$.

In the third unit layer, the lower limit of e is more than 0, may be 0.01 or more, may be 0.02 or more, or may be 0.04 or more. The upper limit of b is 0.10 or less, may be 0.08 or less, and may be 0.06 or less. b may be $0.01 \leq b \leq 0.08$ or may be $0.02 \leq b \leq 0.06$.

a and b in $Ti_aAl_{1-a-b}B_bN$ of the first unit layer and d and e in $Ti_dAl_{1-d-e}B_eN$ of the third unit layer are specified by measuring the composition of each layer using energy dispersive X-ray spectrometry (Energy Dispersive X-ray spectrometry; EDX). Specifically, the measurement is performed with the second unit layer being replaced with the third unit layer in the method of measuring each of the composition of the first unit layer and the composition of the second unit layer as described in the first embodiment.

<<Composition of First-A Layer >>

In the first-A layer, the percentage $(T4/T3) \times 100$ (hereinafter, also referred to as "percentage $(T4/T3) \times 100$") of T4, the number of atoms of titanium, to T3, the total of the numbers of atoms of titanium and aluminum, is 60% or more. According to this, the first-A layer can have excellent crater wear resistance. The lower limit of the percentage $(T4/T3) \times 100$ is 60% or more, may be 63% or more, or may be 66% or more from the viewpoint of improving the crater wear resistance. The upper limit of the percentage $(T4/T3) \times 100$ may be 80% or less, 77% or less, or 75% or less from the viewpoint of improving oxidation resistance. The percentage $(T4/T3) \times 100$ may be 60% or more and 80% or less, 63% or more and 77% or less, or 66% or more and 75% or less.

The percentage $(T4/T3) \times 100$ in the first-A layer is measured by TEM-EDX. Specifically, the measurement is performed with the first layer being replaced with the first-A layer in the method of measuring the percentage $(T2/T1) \times 100$ in the first layer as described in the first embodiment.

<<Nanoindentation Hardness of First-A Layer>>

The nanoindentation hardness of the first-A layer at 25°C may be 30 GPa or more. According to this, the wear resistance of the cutting tool is improved. The lower limit of the nanoindentation hardness may be 32 GPa or more, or 34 GPa or more. The upper limit of the nanoindentation hardness is not particularly limited, but may be 60 GPa or less, 40 GPa or less, or 36 GPa or less from the viewpoint of manufacturing. The nanoindentation hardness may be 30 GPa or more and 60 GPa or less, 32 GPa or more and 60 GPa or less, or 34 GPa or more and 60 GPa or less.

The nanoindentation hardness of the first-A layer at 25°C is measured with the first layer being replaced with the first-A layer in the method of measuring the nanoindentation hardness of the first layer at 25°C as described in the first embodiment.

<<Diameter of Maximum Inscribed Circle of Crystal Grain of First-A Layer>>

The first-A layer consists of a plurality of crystal grains, and the diameter of the maximum inscribed circle of each crystal grain may be 5 nm or more and 500 nm or less. This leads to an improved crater wear resistance of the cutting tool.

The first-A layer of the present disclosure may include not only the plurality of crystal grains but also a region that does not constitute a crystal grain (region in which an atomic arrangement is random) as long as the effect of the present disclosure is not impaired.

The upper limit of the diameter of the maximum inscribed circle of the crystal grain may be 500 nm or less, may be 450 nm or less, or may be 400 nm or less from the viewpoint of improving the wear resistance and the breakage resistance. The lower limit of the diameter of the maximum inscribed circle of the crystal grain may be 5 nm or more, may be 7 nm or more, or may be 10 nm or more from the viewpoint of suppressing film hardness from being decreased due to the crystal grain becoming excessively fine. The diameter of the maximum inscribed circle of the crystal grain may be 5 nm or more and 500 nm or less, may be 7 nm or more and 450 nm or less, or may be 10 nm or more and 400 nm or less.

In the second embodiment, the diameter of the maximum inscribed circle of the crystal grain is measured with the first layer being replaced with the first-A layer in the method of measuring the diameter of the maximum inscribed circle of the crystal grain as described in the first embodiment.

In the second embodiment, the positional relation between the crystal grain and each of the first unit layer and the third unit layer is explained with the second unit layer being replaced with the third unit layer in the positional relation between the crystal grain and each of the first unit layer and the second unit layer as described in the first embodiment.

[Third Embodiment: Method of Manufacturing Cutting Tool]

In a third embodiment, a method of manufacturing the cutting tool according to each of the first embodiment and the second embodiment will be described. The manufacturing method of the third embodiment can include: a step of preparing a substrate; and a step of forming a coating film on the substrate. Details of each step will be described below.

<<Step of Preparing Substrate>>

In the step of preparing the substrate, substrate 10 is prepared. The substrate described in each of the first embodiment and the second embodiment can be used as substrate 10.

<<Step of Forming Coating Film>>

In the step of forming the coating film, coating film 20 is formed on substrate 10. In the third embodiment, coating film 20 can be formed by a physical vapor deposition (PVD) method. Specific examples of the PVD method include an arc ion plating (AIP) method, a balanced magnetron sputtering (BMS) method, an unbalanced magnetron sputtering (UBMS) method, and the like. In the third embodiment, it is preferable to use the arc ion plating.

In the AIP method, an arc discharge is generated using a target material as a cathode. Thus, the target material is evaporated and ionized. Then, the ions are deposited on a surface of substrate 10 to which a negative bias voltage has been applied. The AIP method is excellent in terms of a ratio of ionization of the target material.

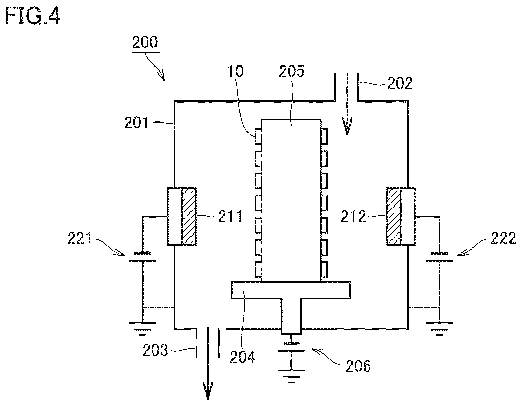

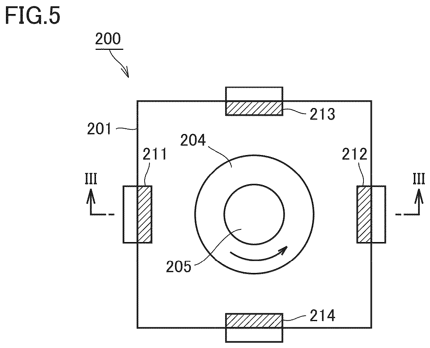

A film forming device used in the AIP method will be described with reference to Figs. 4 and 5. As shown in Fig. 4, a film forming device 200 includes a chamber 201. Chamber 201 is provided with: a gas introduction port 202 for introducing a source material gas into chamber 201; and a gas exhaust port 203 for exhausting the source material gas from chamber 201 to outside. Gas exhaust port 203 is connected to a vacuum pump (not shown). A pressure in chamber 201 is adjusted by introduction amount and exhaust amount of the gas.

A turntable 204 is disposed in chamber 201. A substrate holder 205 for holding substrate 10 is attached to turntable 204. Substrate holder 205 is connected to the negative electrode of bias power supply 206. The positive electrode of bias power supply 206 is grounded.

As shown in Fig. 5, a plurality of target materials 211, 212, 213, 214 are attached to a sidewall of chamber 201. As shown in Fig. 4, target materials 211, 212 are connected to the negative electrodes of DC power supplies 221, 222, respectively. Each of DC power supplies 221, 222 is a variable power supply, and has a positive electrode grounded. Although not shown in Fig. 4, the same applies to target materials 213, 214. Hereinafter, specific operations will be described.

Substrate 10 is held by substrate holder 205. A pressure in chamber 201 is adjusted to $1.0 \times 10^{-4}$ Pa using the vacuum pump. The temperature of substrate 10 is adjusted to 500°C by a heater (not shown) accompanied with film forming device 200, while rotating turntable 204.

An Ar gas is introduced from gas introduction port 202 so as to adjust the pressure in chamber 201 to 3.0 Pa. While maintaining the pressure, the voltage of bias power supply 206 is gradually changed and finally adjusted to -1000 V. Then, the surface of substrate 10 is cleaned by ion bombardment treatment using Ar ions.

Next, when the coating film includes second layer 22, second layer 22 is formed on the surface of substrate 10. For example, a TiCN layer, a TiN layer, or a TiCNO layer is formed on the surface of substrate 10.

Next, the first layer or the first-A layer is formed on the surface of substrate 10 or the surface of second layer 22.

The composition of each target material is selected to obtain the compositions of first unit layer 1, second unit layer 2, and third unit layer 3. Each target material is set at a predetermined position, a nitrogen gas is introduced from gas introduction port 202, and first layer 21 or first-A layer 21A is formed while rotating turntable 204. Conditions for forming each of first layer 21 and the first-A layer are as follows.

<Conditions for Forming Each of First Layer and First-A Layer>

Substrate temperature: 400 to 800°C
Bias voltage: -400 to -20 V
Arc current: 80 to 200 A
Reaction gas pressure: 2 to 10 Pa

Each of the substrate temperature, the reaction gas pressure, the bias voltage, and the arc current are set to a certain value within the above-described range, or is continuously changed within the above-described range.

The multilayer structure in which the first unit layers and the second unit layers are alternately layered or the multilayer structure in which the first unit layers and the third unit layers are alternately layered can be formed by appropriately combining the following methods (A) to (D).

(A) In the AIP method, a plurality of target materials (sintered alloys) having different compositions are used.
(B) In the AIP method, during the film formation, the bias voltage applied to substrate 10 is changed within the bias voltage described in the conditions for forming each of the first layer and the first-A layer.
(C) In the AIP method, a gas flow rate is changed.
(D) In the AIP method, substrate 10 is rotated and a rotation cycle thereof is controlled.

Next, when the coating film includes third layer 23, third layer 23 is formed on the surface of first layer 21 or first-A layer 21A, for example.

In this way, cutting tool 100 including substrate 10 and coating film 20 provided on substrate 10 can be manufactured.

Examples

The present embodiment will be described more specifically with reference to examples. However, the present embodiment is not limited by these examples.

[Example 1]

<Production of Cutting Tool>

Each of cutting tools was produced in the below-described manner and was evaluated in terms of tool life.

As the substrate, a cutting insert (model number: CNMG120408 (provided by Sumitomo Electric Hardmetal)) consisting of a cemented carbide was prepared. The cemented carbide includes WC grains (90 mass%) and Co (10 mass%). The average grain size of the WC grains is 1 to 2 $\mu$m.

A film was formed on the substrate by using a film forming device having the configuration shown in Figs. 4 and 5. First, the substrate was subjected to ion bombardment treatment using Ar ions, thereby cleaning the surface of the substrate. Specific conditions of the ion bombardment treatment are described in the third embodiment.

Next, the target materials were set at predetermined positions of the film forming device. The composition of each target material is adjusted to obtain the compositions of the first unit layer and the second unit layer described in Table 1 and Table 2.

A nitrogen gas was introduced from the gas introduction port, and the first and second unit layers were alternately formed while rotating the turntable, thereby forming the first layer. The conditions for forming the first layer of each sample were as follows: the substrate temperature was 400 to 800°C; the bias voltage was -400 to -20 V; the arc current was 80 to 200 A; and the reaction gas pressure was 2 to 10 Pa. Each of the substrate temperature, the reaction gas pressure, the bias voltage, and the arc current was a certain value within a corresponding one of the above-described ranges, or was continuously changed within the corresponding one of the above-described ranges. Each of the thickness of each of the first and second unit layers, the number of the layered first unit layers, and the number of the layered second unit layers were adjusted by the rotation speed of the substrate.

[Table 1]

Table 1

| Sample No. | First Layer | | | | | | | | | Cutting Test 1 |
| | First Unit Layer ($Ti_aAl_{1-a-b}B_bN$) | | | Second Unit Layer ($Ti_cAl_{1-c}N$) | | (T2/T1) x100 [%] | Hardness [GPa] | Number of Layered Layers | Average Thickness [μm] | Cutting Distance [km] |
| | a | b | Average Thickness [nm] | c | Average Thickness [nm] | | | | | |
| 1 | 0.30 | 0.01 | 4 | 0.70 | 12 | 60.0 | 31 | 400 | 6.4 | 5.8 |
| 2 | 0.30 | 0.05 | 14 | 0.85 | 30 | 67.5 | 33 | 100 | 4.4 | 7.3 |
| 3 | 0.30 | 0.10 | 10 | 1.00 | 12 | 68.2 | 32 | 150 | 3.3 | 6.6 |
| 4 | 0.40 | 0.05 | 35 | 0.85 | 36 | 62.8 | 36 | 200 | 14.2 | 7.1 |
| 5 | 0.50 | 0.01 | 11 | 0.70 | 13 | 60.8 | 33 | 400 | 9.6 | 6.3 |
| 6 | 0.50 | 0.03 | 16 | 0.85 | 17 | 68.0 | 31 | 550 | 18.2 | 6.8 |
| 7 | 0.50 | 0.10 | 10 | 1.00 | 8 | 72.2 | 32 | 400 | 7.2 | 6.6 |
| 8 | 0.37 | 0.08 | 2 | 0.95 | 2 | 66.0 | 34 | 250 | 1.0 | 5.0 |
| 9 | 0.41 | 0.04 | 25 | 0.84 | 25 | 62.5 | 31 | 200 | 10.0 | 6.2 |
| 10 | 0.32 | 0.05 | 50 | 0.90 | 50 | 61.0 | 32 | 200 | 20.0 | 5.8 |
| 11 | 0.35 | 0.07 | 12 | 0.75 | 20 | 60.0 | 33 | 100 | 3.2 | 5.6 |
| 12 | 0.35 | 0.02 | 20 | 0.96 | 35 | 73.8 | 30 | 100 | 5.5 | 5.7 |
| 13 | 0.49 | 0.01 | 30 | 0.98 | 40 | 77.0 | 28 | 100 | 7.0 | 5.4 |
| 14 | 0.37 | 0.05 | 8 | 0.84 | 9 | 61.9 | 36 | 300 | 5.1 | 7.3 |
| 15 | 0.38 | 0.04 | 8 | 1.00 | 8 | 69.0 | 35 | 300 | 4.8 | 7.7 |
| 101 | 0.20 | 0.10 | 12 | 0.85 | 20 | 60.6 | 25 | 200 | 6.4 | 3.2 |
| 102 | 0.60 | 0.10 | 15 | 0.90 | 14 | 74.5 | 23 | 300 | 8.7 | 3.1 |
| 103 | 0.22 | 0.05 | 33 | 0.83 | 34 | 53.0 | 28 | 200 | 13.4 | 3.0 |
| 104 | 0.65 | 0.05 | 38 | 0.85 | 36 | 74.7 | 24 | 200 | 14.8 | 2.8 |
| 105 | 0.40 | 0.15 | 36 | 0.86 | 34 | 62.3 | 21 | 200 | 14.0 | 2.5 |
| 106 | 0.41 | 0.05 | 38 | 0.60 | 31 | 49.5 | 35 | 200 | 13.8 | 3.6 |
| 107 | 0.40 | 0.06 | 78 | 0.86 | 82 | 63.6 | 23 | 90 | 14.4 | 2.6 |
| 108 | 0.42 | 0.04 | 35 | 0.87 | 33 | 63.8 | 34 | 400 | 27.2 | 2.3 |
| 109 | 0.50 | 0.05 | 10 | 0.65 | 40 | 62.0 | 29 | 150 | 7.5 | 3.5 |
| 110 | 0.45 | 0.04 | 10 | 0.85 | 5 | 58.3 | 32 | 200 | 3.0 | 3.5 |

[Table 2]

Table 2

| Sample No. | First Layer | | | | | | | | | Cutting Test 1 |
| | First Unit Layer (Ti$_a$Al$_{1-a-b}$B$_b$N) | | | Second Unit Layer (Ti$_c$Al$_{1-c}$N) | | (T2/T1) x100 [%] | Hardness [GPa] | Number of Layered Layers | Average Thickness [μm] | Cutting Distance [km] |
| | a | b | Average Thickness [nm] | c | Average Thickness [nm] | | | | | |
| 111 | 0.37 | 0.06 | 1 | 0.86 | 1 | 61.5 | 31 | 500 | 1.0 | 2.2 |
| 112 | 0.41 | 0.04 | 60 | 0.84 | 60 | 62.5 | 30 | 100 | 12.0 | 2.6 |
| 113 | 0.38 | 0.06 | 4500 | - | - | 38.0 | 33 | 1 | 4.5 | 1.6 |
| 114 | 0.39 | 0.05 | 13900 | - | - | 39.0 | 33 | 1 | 13.9 | 2.4 |
| 115 | - | - | - | 0.85 | 5200 | 85.0 | 22 | 1 | 5.2 | 1.2 |
| 116 | - | - | - | 0.87 | 14200 | 87.0 | 21 | 1 | 14.2 | 1.4 |
| 117 | 0.39 | 0 | 8 | 0.85 | 8 | 62.0 | 24 | 300 | 4.8 | 1.9 |

<Evaluations>

<<Configuration of Coating Film>>

For each of the coating films of the respective samples, the composition of each of the first unit layer and the second unit layer, the average thickness of the first unit layer, the average thickness of the second unit layer, the average thickness of the first layer, the number of the layered first unit layers and the number of the layered second unit layers, the percentage (indicated as "(T2/T1)×100" in Tables 1 and 2) of the number of atoms of titanium to the total number of atoms of titanium and aluminum in the first layer, and the nanoindentation hardness (indicated as "Hardness" in Tables 1 and 2) of the first layer were measured. A method of measuring each of the items is as described in the first embodiment. Results are shown in Tables 1 and 2. In Table 2, the notation "1" in "Number of Layered Layers" indicates that only one first unit layer or only one second unit layer was formed.

<<Cutting Test 1>>

Each of the cutting tools of the samples was used to perform turning under the below-described conditions, and a cutting distance until the width of crater wear reached 0.3 mm was measured. It is indicated that as the cutting distance is longer, the crater wear resistance is more excellent and the tool life is longer. Results are shown in the column "Cutting Test 1" in each of Tables 1 and 2.

(Cutting Conditions)

    Workpiece: SUS316
    Cutting speed: 120 m/min
    Feed amount: 0.3 mm/rev
    Cut-in amount: 2.0 mm
    Wet type

The above cutting conditions correspond to turning (low-speed high-feed processing) of stainless steel.

<Evaluations>

Samples 1 to 15 correspond to examples of the present disclosure. Samples 101 to 117 correspond to comparative examples. It was confirmed that the tool life of each of samples 1 to 15 was longer than that of each of samples 101 to 117.

[Example 2]

<Production of Cutting Tool>

Each of cutting tools was produced in the below-described manner and was evaluated in terms of tool life.

As a substrate, the same substrate as that of Example 1 was prepared. A coating film was formed on the substrate by using a film forming device having the configuration shown in Figs. 4 and 5. First, the substrate was subjected to ion bombardment treatment using Ar ions, thereby cleaning the surface of the substrate. Specific conditions of the ion bombardment treatment are described in the third embodiment.

Next, the target materials were set at predetermined positions of the film forming device. The composition of each target material was adjusted to obtain the compositions of the first unit layer and the third unit layer described in Tables 3 and 4.

A nitrogen gas was introduced from the gas introduction port, and the first and third unit layers were alternately formed while rotating the turntable, thereby forming the first-A layer. The conditions for forming the first-A layer of each sample were as follows: the substrate temperature was 400 to 800°C; the bias voltage was -400 to -20 V; the arc current was 80 to 200 A; and the reaction gas pressure was 2 to 10 Pa. Each of the substrate temperature, the reaction gas pressure, the bias voltage, and the arc current was a certain value within a corresponding one of the above-described ranges, or was continuously changed within the corresponding one of the above-described ranges. Each of the thickness of each of the first and third unit layers, the number of the layered first unit layers, and the number of the layered third unit layers were adjusted by the rotation speed of the substrate.

[Table 3]

Table 3

| Sample No. | First-A Layer | | | | | | | | | | Cutting Test 2 |
| | First Unit Layer ($Ti_aAl_{1-a-b}B_bN$) | | | Third Unit Layer ($Ti_dAl_{1-d-e}B_eN$) | | | (T4/T3) x100 [%] | Hardness [GPa] | Number of Layered Layers | Average Thickness [μm] | Cutting Distance [km] |
| | a | b | Average Thickness [nm] | d | e | Average Thickness [nm] | | | | | |
|---|---|---|---|---|---|---|---|---|---|---|---|
| 21 | 0.30 | 0.01 | 4 | 0.70 | 0.01 | 12 | 60.0 | 32 | 400 | 6.4 | 12.3 |
| 22 | 0.30 | 0.05 | 17 | 0.85 | 0.05 | 31 | 65.5 | 40 | 100 | 4.8 | 14.4 |
| 23 | 0.30 | 0.10 | 15 | 0.99 | 0.01 | 15 | 64.5 | 35 | 150 | 4.5 | 13.8 |
| 24 | 0.40 | 0.05 | 30 | 0.85 | 0.05 | 35 | 64.2 | 42 | 200 | 13.0 | 16.2 |
| 25 | 0.50 | 0.01 | 9 | 0.70 | 0.10 | 18 | 63.3 | 36 | 400 | 10.8 | 14.7 |
| 26 | 0.50 | 0.03 | 15 | 0.85 | 0.05 | 17 | 68.6 | 37 | 550 | 17.6 | 16.8 |
| 27 | 0.50 | 0.01 | 10 | 0.99 | 0.01 | 9 | 73.2 | 34 | 400 | 7.6 | 13.5 |
| 28 | 0.43 | 0.07 | 2 | 0.96 | 0.04 | 2 | 69.5 | 44 | 250 | 1.0 | 12.0 |
| 29 | 0.40 | 0.05 | 25 | 0.85 | 0.02 | 25 | 62.5 | 35 | 200 | 10.0 | 15.3 |
| 30 | 0.31 | 0.05 | 50 | 0.90 | 0.06 | 50 | 60.5 | 37 | 200 | 20.0 | 15.0 |
| 31 | 0.35 | 0.07 | 12 | 0.74 | 0.05 | 22 | 60.0 | 42 | 100 | 3.4 | 13.5 |
| 36 | 0.35 | 0.02 | 18 | 0.95 | 0.02 | 32 | 73.4 | 30 | 100 | 5.0 | 13.2 |
| 37 | 0.47 | 0.02 | 26 | 0.93 | 0.05 | 45 | 76.2 | 29 | 100 | 7.1 | 12.0 |
| 40 | 0.38 | 0.05 | 8 | 0.85 | 0.04 | 9 | 62.9 | 41 | 300 | 5.1 | 15.3 |
| 120 | 0.20 | 0.10 | 15 | 0.87 | 0.04 | 24 | 61.2 | 28 | 200 | 7.8 | 7.2 |
| 121 | 0.60 | 0.10 | 14 | 0.89 | 0.03 | 12 | 73.4 | 24 | 300 | 7.8 | 7.8 |
| 122 | 0.19 | 0.06 | 31 | 0.86 | 0.06 | 33 | 53.5 | 30 | 200 | 12.8 | 8.4 |
| 123 | 0.58 | 0.05 | 28 | 0.85 | 0.05 | 32 | 72.4 | 27 | 200 | 12.0 | 8.1 |
| 124 | 0.41 | 0.14 | 29 | 0.86 | 0.04 | 34 | 65.3 | 22 | 200 | 12.6 | 5.1 |
| 125 | 0.42 | 0.05 | 32 | 0.60 | 0.05 | 31 | 50.9 | 38 | 200 | 12.6 | 7.0 |
| 126 | 0.40 | 0.05 | 31 | 0.85 | 0.16 | 31 | 62.5 | 22 | 200 | 12.4 | 4.8 |

EP 4 703 070 A1

18

(continued)

| Sample No. | First-A Layer | | | | | | | | | | Cutting Test 2 |
| | First Unit Layer ($Ti_aAl_{1-a-b}B_bN$) | | | Third Unit Layer ($Ti_dAl_{1-d-e}B_eN$) | | | (T4/T3) x100 [%] | Hardness [GPa] | Number of Layered Layers | Average Thickness [$\mu$m] | Cutting Distance [km] |
| | a | b | Average Thickness [nm] | d | e | Average Thickness [nm] | | | | | |
| 127 | 0.39 | 0.04 | 76 | 0.83 | 0.05 | 74 | 60.7 | 26 | 90 | 13.5 | 6.8 |
| 128 | 0.40 | 0.06 | 33 | 0.87 | 0.06 | 32 | 63.1 | 38 | 400 | 26.0 | 5.0 |
| 129 | 0.48 | 0.05 | 12 | 0.64 | 0.15 | 45 | 60.6 | 25 | 150 | 8.6 | 6.0 |

[Table 4]

[Table 4]

Table 4

| Sample No. | First-A Layer | | | | | | | | | | Cutting Test 2 |
|---|---|---|---|---|---|---|---|---|---|---|---|
| | First Unit Layer ($Ti_aAl_{1-a-b}B_bN$) | | | Third Unit Layer ($Ti_dAl_{1-d-e}B_eN$) | | | (T4/T3) x100 [%] | Hardness [GPa] | Number of Layered Layers | Average Thickness [μm] | Cutting Distance [km] |
| | a | b | Average Thickness [nm] | d | e | Average Thickness [nm] | | | | | |
| 130 | 0.47 | 0.04 | 13 | 0.85 | 0.05 | 5 | 57.6 | 33 | 200 | 3.6 | 6.9 |
| 131 | 0.37 | 0.05 | 1 | 0.85 | 0.04 | 1 | 61.0 | 34 | 500 | 1.0 | 6.6 |
| 132 | 0.41 | 0.05 | 60 | 0.86 | 0.05 | 60 | 63.5 | 33 | 100 | 12.0 | 8.1 |
| 133 | 0.38 | 0.06 | 4500 | - | - | - | 38.0 | 33 | 1 | 4.5 | 4.5 |
| 134 | 0.38 | 0.05 | 12900 | - | - | - | 38.0 | 33 | 1 | 12.9 | 6.1 |
| 135 | - | - | - | 0.85 | 0 | 5100 | 85.0 | 22 | 1 | 5.1 | 3.0 |
| 136 | - | - | - | 0.85 | 0.05 | 13200 | 85.0 | 27 | 1 | 13.2 | 4.2 |
| 137 | 0.39 | 0 | 8 | 0.85 | 0 | 8 | 62.0 | 28 | 300 | 4.8 | 5.4 |

EP 4 703 070 A1

<Evaluations>

<<Configuration of Coating Film>>

For each of the coating films of the respective samples, the compositions of the first unit layer and the third unit layer, the average thickness of the first unit layer, the average thickness of the third unit layer, the average thickness of the first-A layer and the number of the layered first unit layers and the number of the layered third unit layer, the percentage (indicated as "(T4/T3)×100" in Tables 3 and 4) of the number of atoms of titanium to the total of the numbers of atoms of titanium and aluminum in the first-A layer, and the nanoindentation hardness (indicated as "Hardness" in Tables 3 and 4) of the first-A layer were measured. A method of measuring each of the items is described in the first embodiment. Results are shown in Tables 3 and 4. In Table 4, the notation "1" in "Number of Layered Layers" indicates that only one first unit layer or only one third unit layer was formed.

<<Cutting Test 2>>

Each of the cutting tools of the samples was used to perform turning under the below-described conditions, and a cutting distance until the width of crater wear reached 0.3 mm was measured. It is indicated that as the cutting distance is longer, the crater wear resistance is more excellent and the tool life is longer. Results are shown in the column "Cutting Test 2" in Table 2.

(Cutting Conditions)

Workpiece: SCM435
Cutting speed: 300 m/min
Feed amount: 0.15 mm/rev
Cut-in amount: 1.0 mm
Wet type

The above cutting conditions correspond to turning (high-speed low-feed processing) of chromium molybdenum steel.

<Evaluations>

Samples 21 to 40 correspond to examples of the present disclosure. Samples 120 to 137 correspond to comparative examples. It was confirmed that the tool life of each of samples 11 to 40 was longer than that of each of samples 120 to 137.

Although the embodiments and examples of the present disclosure have been described as described above, it is also initially expected to appropriately combine or various modify the configurations of the above-described embodiments and examples.

The embodiments and examples disclosed herein are illustrative and non-restrictive in any respect. The scope of the present disclosure is defined by the terms of the claims, rather than the embodiments and examples described above, and is intended to include any modifications within the scope and meaning equivalent to the terms of the claims.

REFERENCE SIGNS LIST

1 first unit layer; 2 second unit layer; 3 third unit layer; 10 substrate; 20 coating film; 21 first layer; 21A first-A layer; 22 second layer; 23 third layer; 24, 24a, 24b, 24c crystal grain; 25 crystal grain boundary; 50 atom; 100 cutting tool; 200 film forming device; 201 chamber; 202 gas introduction port; 203 gas exhaust port; 204 rotation table; 205 substrate holder; 206 bias power supply; 211, 212, 213, 214 target material; 221, 222 DC power supply.

**Claims**

1. A cutting tool comprising a substrate and a coating film provided on the substrate, wherein

the coating film includes a first layer,

the first layer consists of a multilayer structure in which a first unit layer and a second unit layer are alternately layered,

an average thickness of the first unit layer is 2 nm or more and 50 nm or less,

an average thickness of the second unit layer is 2 nm or more and 50 nm or less,

an average thickness of the first layer is 1.0 $\mu$m or more and 20 $\mu$m or less,

the first unit layer consists of $Ti_aAl_{1-a-b}B_bN$, where

$$0.30 \leq a \leq 0.50,$$

and

$$0 < b \leq 0.10,$$

the second unit layer consists of $Ti_cAl_{1-c}N$, where

$$0.70 \leq c \leq 1.00,$$

and

in the first layer, a percentage $(T2/T1) \times 100$ of T2, the number of atoms of titanium, to T1, a total of the numbers of atoms of titanium and aluminum, is 60% or more.

2. The cutting tool according to claim 1, wherein a nano indentation hardness of the first layer at 25°C is 30 GPa or more.

3. A cutting tool comprising a substrate and a coating film provided on the substrate, wherein

the coating film includes a first-A layer,

the first-A layer consists of a multilayer structure in which a first unit layer and a third unit layer are alternately layered,

an average thickness of the first unit layer is 2 nm or more and 50 nm or less,

an average thickness of the third unit layer is 2 nm or more and 50 nm or less,

an average thickness of the first-A layer is 1.0 $\mu$m or more and 20 $\mu$m or less,

the first unit layer consists of $Ti_aAl_{1-a-b}B_bN$, where

$$0.30 \leq a \leq 0.50,$$

and

$$0 < b \leq 0.10,$$

the third unit layer consists of $Ti_dAl_{1-d-e}B_eN$, where

$$0.70 \leq d < 1.00,$$

and

$$0 < e \leq 0.10,$$

and

in the first-A layer, a percentage $(T4/T3) \times 100$ of T4, the number of atoms of titanium, to T3, a total of the numbers of atoms of titanium and aluminum, is 60% or more.

4. The cutting tool according to claim 3, wherein a nano indentation hardness of the first-A layer at 25°C is 30 GPa or more.

FIG.1

FIG.1A

FIG.2

FIG.3

FIG.3A

FILM
THICKNESS
DIRECTION

FIG.4

FIG.5

# EP 4 703 070 A1

## INTERNATIONAL SEARCH REPORT

| International application No. |
|---|
| PCT/JP2023/016836 |

### A. CLASSIFICATION OF SUBJECT MATTER

*B23B 27/14*(2006.01)i; *C23C 14/06*(2006.01)i
FI: B23B27/14 A; C23C14/06 A; C23C14/06 P

According to International Patent Classification (IPC) or to both national classification and IPC

### B. FIELDS SEARCHED

Minimum documentation searched (classification system followed by classification symbols)

B23B27/00-29/34; B23C1/00-9/00; B23B51/00-51/14; B23P5/00-17/06; B23P23/00-25/00; C23C14/00-14/58; C23C16/00-16/56

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2007-15070 A (MITSUBISHI MATERIALS CORPORATION) 25 January 2007 (2007-01-25) entire text, all drawings | 1-4 |
| A | WO 2017/175803 A1 (TUNGALOY CORPORATION) 12 October 2017 (2017-10-12) entire text, all drawings | 1-4 |
| A | JP 2018-202505 A (SUMITOMO ELECTRIC INDUSTRIES, LTD.) 27 December 2018 (2018-12-27) entire text, all drawings | 1-4 |
| A | JP 7-310171 A (KABUSHIKI KAISHA KOBE SEIKO SHO) 28 November 1995 (1995-11-28) entire text, all drawings | 1-4 |
| A | WO 2022/003014 A1 (AB SANDVIK COROMANT) 06 January 2022 (2022-01-06) entire text, all drawings | 1-4 |

☐ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **25 May 2023** | **06 June 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/016836**

| Patent document cited in search report | | | Publication date (day/month/year) | Patent family member(s) | | | Publication date (day/month/year) |
|---|---|---|---|---|---|---|---|
| JP | 2007-15070 | A | 25 January 2007 | (Family: none) | | | |
| WO | 2017/175803 | A1 | 12 October 2017 | US | 2019/0061013 | A1 | |
| | | | | entire text, all drawings | | | |
| | | | | EP | 3441168 | A1 | |
| JP | 2018-202505 | A | 27 December 2018 | (Family: none) | | | |
| JP | 7-310171 | A | 28 November 1995 | (Family: none) | | | |
| WO | 2022/003014 | A1 | 06 January 2022 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017193004 A
- JP 2011224717 A